# EUROPÄISCHE PATENTSCHRIFT

(11) **EP 0 762 212 B1**
(45) Veröffentlichungstag und Bekanntmachung des Hinweises auf die Patenterteilung: **12.01.2000**
(21) Anmeldenummer: 95114007.8
(22) Anmeldetag: 06.09.1995
(51) Int. Cl.: G03F 7/12, B41C 1/14, G03F 7/20

(54) **Verfahren zum Herstellen einer Siebdruckschablone**
Process for making a printing screen
Procédé pour fabriquer un écran de sérigrapie

(43) Veröffentlichungstag der Anmeldung: 12.03.1997
(73) Patentinhaber: Schablonentechnik Kufstein Aktiengesellschaft, 6330 Kufstein (AT)
(72) Erfinder: Fischer, Hannes, 6300 Wörgl (AT)
(74) Vertreter: TER MEER STEINMEISTER & PARTNER GbR

(56) Entgegenhaltungen:
- EP-A- 0 122 223
- EP-A- 0 305 103
- EP-A- 0 332 044
- EP-A- 0 593 806
- EP-A- 0 741 335

## Beschreibung

Die Erfindung betrifft ein Verfahren zum Herstellen einer Siebdruckschablone gemäß dem Oberbegriff des Patentanspruchs 1.

Ein derartiges Verfahren ist bereits aus der EP 0 305 103 A1 bekannt. Es handelt sich hier um ein Verfahren zum Herstellen einer Siebdruckschablone, insbesondere zum Bedrucken von Textilien, bei dem ein an seiner äußeren Oberfläche mit einer Lackschicht beschichteter Trägerkörper mittels eines Laserstrahls bestrahlt wird, um in diese ein gewünschtes Muster einzubringen. Zu diesem Zweck wird die Lackschicht bereichsweise weggebrannt. Die Strahlungswellenlänge des Laserstrahls ist dabei größer als 450 nm.

Ein ähnliches Verfahren ist auch aus der EP 0 593 806 A1 bekannt. Hier erfolgt jedoch die ortsselektive Belichtung einer photoempfindlichen Lackschicht mit Hilfe eines UV-Lasers zwecks Vernetzung bzw. Aushärtung der belichteten Stellen der Lackschicht, wonach die so belichtete Lackschicht entwickelt wird.

Bekannt sind aus der EP 0 332 044 A1 weiterhin lichtempfindliche Aufzeichnungsmaterialien zur Verwendung bei der Herstellung von Siebdruckformen. Diese Aufzeichnungsmaterialien sind in einem Wellenlängenbereich zwischen 350 und 550 nm empfindlich, wobei sie den bekannten Gemischen, die nur im nahen UV-Bereich empfindlich sind, mindestens ebenbürtig sind. Dadurch ist eine praxisgerechte, rasche Belichtung mit wenig energiereichen, im sichtbaren Bereich emittierenden Lasern möglich.

Nicht zuletzt ist eine photopolymerisierbare Zusammensetzung, die Metallocene enthält, aus der EP 0 122 223 A3 bekannt. Diese Zusammensetzung zeichnet sich durch eine hohe Empfindlichkeit, Stabilität gegen Luft und thermische Einwirkung, und durch eine hohe Wirksamkeit im Bereich von UV-Licht bis sichtbarem Licht aus.

Darüber hinaus geht aus der nicht vorveröffentlichten EP 0 741 335 A1 ein Verfahren zum Herstellen einer Flexodruckplatte hervor, bei dem ein an seiner äußeren Oberfläche mit einer Fotolackschicht und einer IR-empfindlichen Schicht beschichteter Trägerkörper mittels eines Laserstrahls bestrahlt wird, um in diese ein gewünschtes Muster einzubringen. Dabei kann die Strahlungswellenlänge des Laserstrahls größer als 450 nm sein, wobei die Ein-/Ausschaltfrequenz des Laserstrahls zwischen etwa 0,5 Megabit pro Sekunde und etwa 1,0 Megabit pro Sekunde liegt.

Der Erfindung liegt die Aufgabe zugrunde, ein Verfahren der im Oberbegriff des Anspruchs 1 genannten Art so weiterzubilden, daß sich eine bessere Konturenschärfe des in die Lackschicht einzubringenden Musters ergibt.

Die Lösung der gestellten Aufgabe ist im kennzeichnenden Teil des Patentanspruchs 1 angegeben. Vorteilhafte Ausgestaltungen der Erfindung sind den Unteransprüchen zu entnehmen.

Es gibt bereits eine Anzahl von Lasern, die im längerwelligen Strahlungsbereich emittieren und eine vergleichsweise hohe Strahlungsleistung aufweisen. Derartige Laser sind im Vergleich zum kürzerwelligen Strahlungsbereich bei etwa gleicher Strahlausgangsleistung billiger herstellbar, so daß durch ihren Einsatz die Herstellung von Siebdruckschablonen verbilligt werden kann. Infolge ihrer höheren Strahlausgangsleistung können darüber hinaus weniger empfindliche Lackschichten zum Einsatz kommen, was die Wirtschaftlichkeit des Herstellungsverfahrens weiter erhöht. Auch lassen sich bei höherer Strahlausgangsleistung vergleichsweise dickere Lackschichten oder dickere Mehrschichtsysteme verwenden, falls dies aus Festigkeits- bzw. Haftungsgründen oder aus Gründen der Empfindlichkeitssteigerung erforderlich sein sollte, so daß auch diesbezüglich weitere Vorteilen erhalten werden.

Die Strahlungswellenlänge des Laserstrahls liegt oberhalb von 450 nm, vorzugsweise im sichtbaren Spektralbereich, da in diesem Spektralbereich arbeitende Laser besonders kostengünstig auf dem Markt erhältlich sind und sich auch die Empfindlichkeit der Lackschicht relativ einfach einstellen läßt.

Die Strahlungswellenlänge des Laserstrahls kann aber auch im infraroten Spektralbereich liegen, da auch hier preisgünstige Laser zur Verfügung stehen und die Empfindlichkeitseinstellung der Lackschicht entsprechend möglich ist.

Grundsätzlich besteht die Möglichkeit, die Lackschicht bzw. ein aus mehreren übereinanderliegenden Lackschichten bestehendes Schichtsystem mittels des Laserstrahls direkt abzutragen bzw. wegzubrennen, oder aber mittels des Laserstrahls nur zu belichten und damit zu vernetzen, falls es sich beim Lack um ein vernetzbares bzw. polymerisierbares Material handelt. Im zuletzt genannten Fall schließt sich dann ein Entwicklungsschritt an, um die nicht belichteten Lackschichten herauszuwaschen.

Im Falle der Polymerisation durch Laserstrahlung kann vorzugsweise bei einer Strahlungswellenlänge von etwa 488 nm sowie bei einer optischen Strahlungsleistung von 150 mW garbeitet werden, um optimale Belichtungsergebnisse zu erzielen.

Ein kostengünstiges Mittel zum Ein- und Ausschalten des Laserstrahls kann in einem akustooptischen Modulator gesehen werden. Erfindungsgemäß liegt dabei die Ein-Ausschaltfrequenz des Laserstrahls im Bereich von 1.0 bis 1,3 MHz, was durch den akustooptischen Modulator realisierbar ist, so daß auch eine hinreichend gute Konturenschärfe des in die Lackschicht einzubringenden Musters erhalten wird. Selbstverständlich könnte anstelle des akustooptischen Modulators auch ein elektrooptischer Modulator verwendet werden.

Prinzipiell kann als Trägerkörper ein ebener oder zylinderförmiger Trägerkörper verwendet werden. Hierbei kann es sich um bereits gesiebte Trägerkörper oder um solche mit geschlossener Wandfläche handeln. Im zuletzt genannten Fall erfolgt dann nach Einbringen des Musters in die Lackschicht und nach dem Entwicklungsschritt ein weiterer Schritt, in welchem die freigelegten Bereiche der Lackschicht mit Metall aufgefüllt werden, um eine Siebdruckschablone zu bilden, die anschließend vom Trägerkörper abgenommen-wird.

Für das Auftragen der Lackschicht stehen mehrere Möglichkeiten zur Verfügung. So kann der Lack zur Bildung der Lackschicht mittels einer Düseneinrichtung aufgesprüht werden. Dies trifft auch für einen aus mehreren Schichten bestehendes Schichtsystem zu, wobei nach dem Aufbringen jeder Schicht ein Trocknungsvorgang erfolgt. Das Aufsprühen des Lacks kann sowohl bei ebenen als auch bei zylindrischen Trägerkörpern durchgeführt werden.

Bei zylindrischen Trägerkörpern kann darüber hinaus das Aufbringen der Lackschicht mittels einer Ringrakel erfolgen. Hierzu wird der zylindrische Trägerkörper vertikal aufgestellt und die ihn umgebende Ringrakel entlang seiner Vertikalachse bewegt. Handelt es sich um einen Trägerkörper mit geschlossener Wandfläche, so wird vorzugsweise eine Tauchringrakel verwendet, die zum Aufbringen der Lackschicht von oben nach unten geführt wird. Bei einem bereits siebförmigen zylindrischen Trägerkörper kann die Ringrakel entweder von oben nach unten oder von unten nach oben geführt werden, um den Lack aufzutragen. Durch Wiederholen der genannten Vorgänge und Durchführen eines jeweiligen Trocknungsschritts lassen sich somit auch mehrere aufeinanderliegende Lackschichten bilden, falls dies erforderlich ist.

Zur Bildung der Lackschicht kann z.B. ein Lack aufgetragen werden, der wenigstens einen Negativ-Flüssigresist mit wenigstens einem darin vorhandenen Photoinitiator aufweist. Diese Lackschicht ist durch Laserstrahlung vernetzbar bzw. aushärtbar, wobei deren Strahlungsempfindlichkeit durch den jeweils verwendeten Photoinitiator eingestellt werden kann. So kommen für den sichtbaren Spektralbereich und den infraroten Spektralbereich unterschiedliche Photoinitiatoren zum Einsatz, beispielsweise für den sichtbaren Spektralbereich ein Metallocen oder eine ein Metallocen enthaltende Mischung.

Der Lack kann dabei einen leicht abdampfbaren Verdünner enthalten, um eine für das Auftragen der Lackschicht geeignete Viskosität einzustellen. Statt dessen oder zusätzlich kann er aber auch ein Monomer enthalten, das den Lack im Ausgangszustand weniger zäh bzw. fest werden läßt. Dieses Monomer wird anstelle eines Lösungsmittels verwendet und später in die Ketten des Lack- bzw. Harzsystems eingebaut, was zu einer schnelleren Aushärtung des Lacks führt.

Der Lack kann darüber hinaus nach einer weiteren Ausgestaltung der Erfindung auch einen Farbstoff enthalten, dessen Farbe vorzugsweise komplementär zu der der Strahlungswellenlänge entsprechenden Farbe ist. was zu besserer Strahlungsabsorption und erhöhtem Vernetzungswirkungsgrad führt. Beim Farbstoff kann es sich z.B. um Zaponrot handeln.

Nach einer weiteren Ausgestaltung der Erfindung kann vor der Bestrahlung der Lackschicht auf diese eine weitere organische Lackschicht aufgetragen werden, die die den Photoinitiator enthaltende Lackschicht im wesentlichen vor Beeinflussung durch Sauerstoff schützt. Durch diese weitere organische Lackschicht läßt sich somit die Empfindlichkeit der darunterliegenden Lackschicht bzw. deren Polymerisationsfähigkeit erheblich steigern.

Die weitere organische Lackschicht kann z.B. eine Gelatineschicht oder eine solche sein, die wenigstens ein in Wasser gelöstes Thermoplast enthält. Hierbei kann es sich um einen Polyvinylalkohol handeln, der zusätzlich auch einen Fettalkoholpolyglykolether enthalten kann, so daß sich eine weitere Empfindlichkeitssteigerung der darunterliegenden polymerisierbaren Lackschicht ergibt.

Durch Verwendung von entionisiertem Wasser wird darüber hinaus eine Eintrübung der weiteren Lackschicht verhindert, so daß keine Verringerung der Empfindlichkeit des Gesamtschichtsystems auftreten kann.

Ausführungsbeispiele der Erfindung werden nachfolgend unter Bezugnahme auf die Zeichnung näher beschrieben. Es zeigen:
- **Fig. 1**: einen Verfahrensschritt zur Beschichtung eines hohlzylindrischen Trägerkörpers mit einer photoempfindlichen Lackschicht;
- **Fig. 2**: einen entsprechenden Verfahrensschritt. bei dem die photoempfindliche Lackschicht auf den hohlzylindrischen Trägerkörper aufgesprüht wird;
- **Fig. 3**: eine Belichtungsvorrichtung zum Belichten der photoempfindlichen Lackschicht;
- **Fig. 4**: eine Seitenansicht der Belichtungsvorrichtung nach Fig. 3;
- **Fig. 5**: eine weitere Belichtungsvorrichtung zur Belichtung der photoempfindlichen Lackschicht;
- **Fig. 6**: eine Seitenansicht der weiteren Belichtungsvorrichtung nach Fig. 5; und

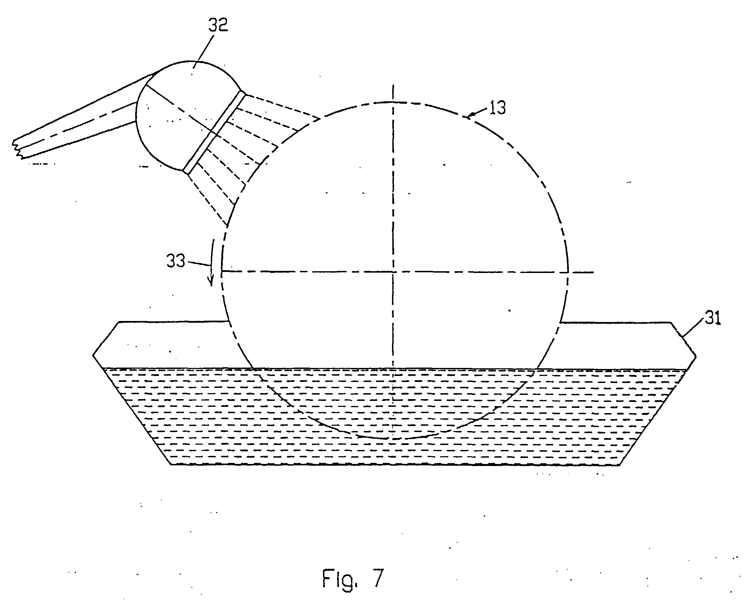

- **Fig. 7**: einen Verfahrensschritt zur Entwicklung der photoempfindlichen Lackschicht.

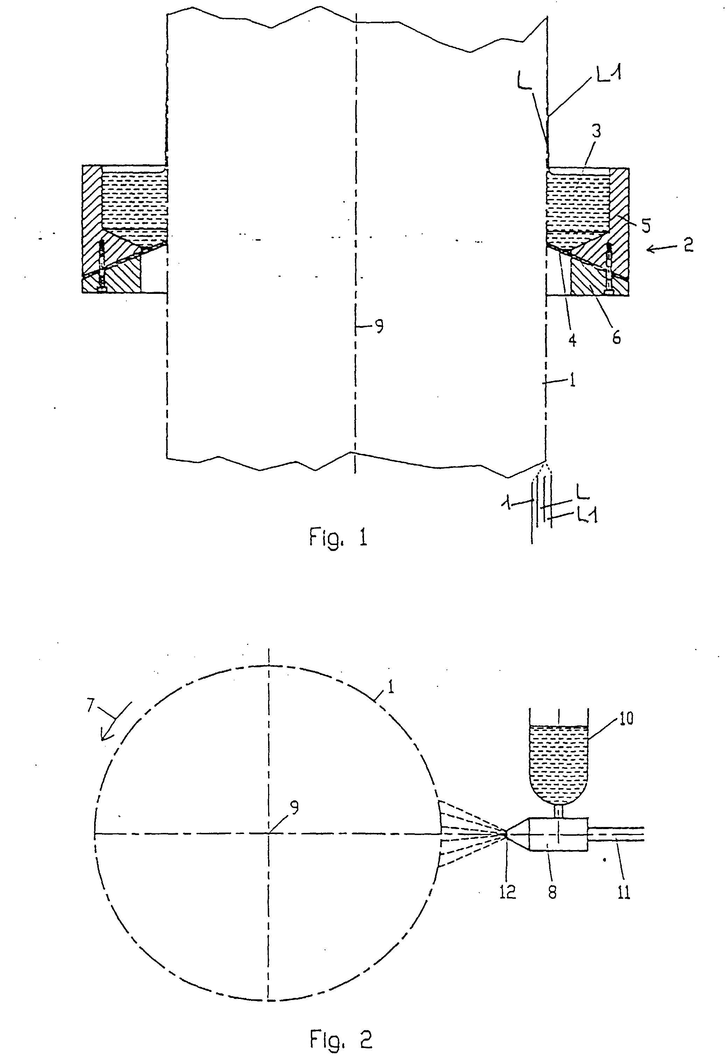

In der Fig. 1 ist ein hohlzylindrischer Trägerkörper gezeigt, welcher unter Verwendung einer Tauchringrakel 2 mit einem flüssigen Photopolymer beschichtet wird. Der hohlzylindrische Trägerkörper 1 besteht hier aus Metall und weist eine geschlossene Mantelfläche auf. Das flüssige Photopolymer befindet sich in einer kreisringförmigen Wanne 3 und kann dank einer dichtend an dem Trägerkörper 1 anliegenden Gummilippe 4 nicht aus der Wanne 3 herausfließen. Die Gummilippe 4 wird zwischen einem Ringrakeloberteil 5 und einem Ringrakelunterteil 6 gehalten. Das Photo-polymer weist etwa eine Viskosität eines zähen Motoröls auf und kann zufolge einer nach abwärts gerichteten Bewegung der Ringrakel 2 auf die Außenseite des Trägerkörpers 1 aufgebracht werden.

Besteht im Gegensatz dazu der hohlzylindrische Träger 1 aus einem Rundsieb, so kann bei der nach abwärts gerichteten Bewegung der Ringrakel 2 das Photopolymer nicht durch das Rundsieb 1 in dessen Innenraum fließen. Der Grund liegt darin, daß der statische Druck, unter dem das zähflüssige Photopolymer steht, nur dem Stand der Flüssigkeitshöhe in der Wanne 3 der Ringrakel 2 entspricht und daher sehr gering ist. Auch kommt dieser statische Druck auf einem Längenabschnitt des Rundsiebes 1 nur ganz kurze Zeit zur Wirkung, und zwar solange, als die Ringrakel 2 aufgrund ihrer nach abwärts gerichteten Geschwindigkeit benötigt, um die Höhe des Flüssigkeitsstands in der Wanne 3 zu durchlaufen. Das Rundsieb 1 ist so engmaschig bzw. weist so kleine Bohrungen auf, daß der geringe statische Druck zwar ausreicht, das Polymer innerhalb der verfügbaren Zeit in die Bohrungen zu drücken und diese aufzufüllen, nicht aber reicht dieser Druck aus, um die sich gegen das Innere des Rundsiebes 1 in jeder kleinen Kapillarenbohrung ausbildende Flüssigkeitsmembran zu überdrücken und so aufzureißen. Dadurch ist ein Austritt von Photopolymer in das Innere des Rundsiebes 1 auch bei Verringerung der Absenkgeschwindigkeit der Ringrakel 2 weitgehend unmöglich.

Sowohl im Falle des Hohlzylinders mit geschlossener Wandfläche als auch im Falle des Rundsiebes wird die Absenkgeschwindigkeit der Ringrakel 2 so gewählt, daß die auf dem Rundsieb 1 verbleibende Polymerschicht L die gewünschte Dicke aufweist. Die Dicke der Photopolymerschicht ist dabei größer wenn die Ringrakel 2 schnell abgesenkt wird, während die Dicke geringer wird, je langsamer die Abwärtsbewegung der Ringrakel 2 ist. Dies ist verständlich, wenn man bedenkt, daß das Photopolymer eine Lösung von (lichtempfindlichen) Harzen in einem leicht abdampfbaren Lösungsmittel ist. Das aus der Wanne 3 herausgezogene Rundsieb 1 reißt einen entsprechend dicken Flüssigkeitsfilm mit sich. Die innerste Schicht dieses Flüssigkeitsfilms haftet an dem Rundsieb 1, während die äußeren Schichten des Flüssigkeitsfilms infolge ihres Gewichts nach abwärts in die Wanne 3 zurückfließen. Dabei fließen die äußersten Schichten am schnellsten zurück.

Während dieses Vorgangs dampft das Lösungsmittel ab. Je dünner die Flüssigkeitsschicht geworden ist, desto stärker sind die spezifischen Lösungsmittelverluste der verbleibenden Schicht und damit deren Viskositätssteigerung, da die Menge des abdampfenden Lösungsmittels pro Zeiteinheit nur von der Umgebungstemperatur und der Oberfläche abhängt und damit im wesentlichen konstant bleibt.

Schließlich wird eine so hohe Viskosität erreicht, daß die Geschwindigkeit der äußersten und nach unten abfließenden Schichten der Absenkgeschwindigkeit entspricht und somit das Photopolymer nicht mehr die Wanne 3 erreichen kann. Dieser Beschichtungsvorgang ergibt daher auch dann noch gleichmäßige Dicken der Photopolymerschicht, wenn der Trägerkörper keine genaue kreiszylindrische Oberfläche aufweist, sondern z.B. leicht verbeult ist.

Ist der zylindrische Trägerkörper 1 in Form eines Rundsiebes ausgebildet, so könnte die Ringrakel 2 auch von unten nach oben bewegt werden. In diesem Fall würde man zweckmäßigerweise die Gummilippe 4 durch einen eng am Rundsieb anliegenden O-Ring ersetzen, durch den wenigstens zum Teil das Photopolymer auch in die Sieböffnungen gedrückt wird.

Alternativ kann aber auch eine Beschichtung des hohlzylindrischen Trägerkörpers 1, egal ob er eine geschlossene oder siebförmige Wandfläche aufweist, mittels einer Zerstäuberdüse 8 erfolgen, wenn er gemäß Fig. 2 in Richtung des Pfeils 7 gedreht wird, also um seine Längsachse 9 herum. Dabei wird die Zerstäuberdüse 8 in Richtung der Längsachse 9 des Trägerkörpers 1 bewegt. Das Photopolymer, welches sich in einem Becher 10 oberhalb der Zerstäuberdüse 8 befindet, wird durch eine injektorartige Vorrichtung im Inneren der Zerstäuberdüse 8 aus dem Becher 10 angesaugt und mit der den Injektor betreibenden Druckluft, die durch einen Schlauch 1 1 zugeführt wird, durch ein Mundstück 12 der Zerstäuberdüse 8 ausgestoßen und dort nach an sich bekannter Weise zerstäubt. Dies wird z.B. durch einen unter mehr als 2 bar Überdruck stehenden Luftstrahl erreicht, in welchem intensive Ultraschallwellen auftreten, durch die das Photopolymer in kleinste Flüssigkeitsteilchen zerrissen wird. Dank der Drehbewegung des Trägerkörpers 1 und der gleichzeitig erfolgenden Vorschubbewegung der Zerstäuberdüse 8 in axialer Richtung des Trägerkörpers 1 wird der Photopolymernebel gleichmäßig auf der Oberfläche des Trägerkörpers 1 verteilt.

Bei dem verwendeten flüssigen Photopolymer bzw. Lack kann es sich um ein Acrylharz oder um ein Acrylatharz handeln. Dieses basiert auf einer Mischung von monomeren und polymeren Acryl- und/oder Methacrylsäureestern. Das Monomer der Acrylsäure bzw. des Acrylsäureesters hat die folgende Strukturformel:

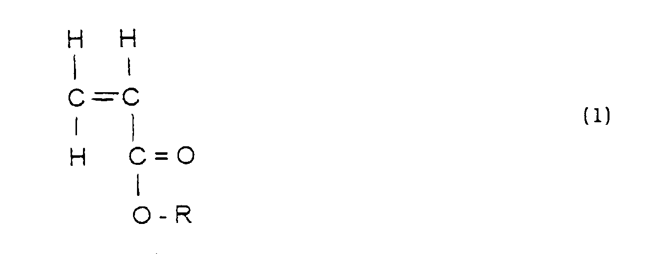

Das Radikal R kann dabei H, CH₃, CH₂-CH₃ oder CH₂-CH₂-CH₂-CH₃ sein. In diesen Fällen bezeichnet man das Monomer dann jeweils als Acrylsäure, Acrylsäuremethylester, Acrylsäureethylester bzw. als Acrylsäure-butylester.

Nach der Polymerisation entsteht ein langkettiges Polymer der folgenden Gestalt.

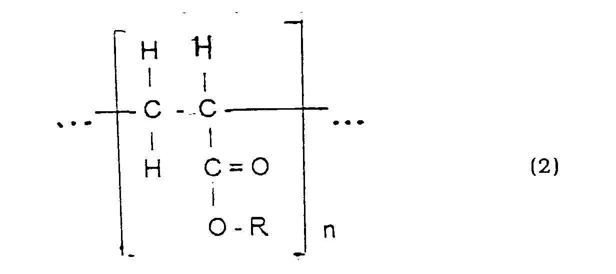

Die Polymerisate heißen dann ensprechend: Polyacrylsäure, Polyacrylsäuremethylester, Polyacrylsäureethylester bzw. Polyacrylsäurebutylester.

Dagegen haben Methacrylsäure bzw. Methacrylsäureester den folgenden strukturellen Aufbau:

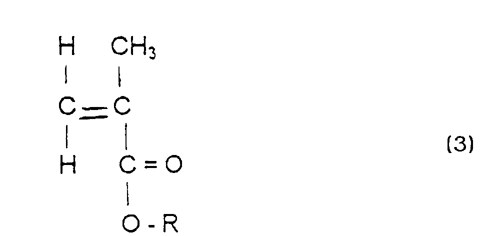

Das Radikal R kann dabei H, CH₃, CH₂-CH₃, CH₂-CH₂-CH₃ bzw. CH(CH₃)-CH₃ sein. Je nach Radikal R bezeichnet man dann die Verbindung als Methacrylsäure, Methacrylsäuremethylester, Methacrylsäureethylester, Methacrylsäurepropylester bzw. Methacrylsäureisopropylester.

Entsprechend entstehen durch die Polymerisation Verbindungen der Formel:

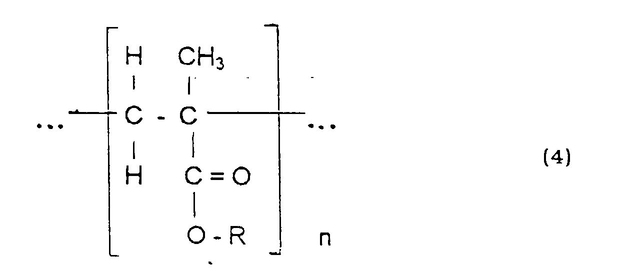

Es handelt sich jetzt sinngemäß um Polymethacrylsäure, Polymethacrylsäuremethylester, Polymethacrylsäureethylester, Polymethacrylsäurepropylester und Polymethacrylsäureisopropylester.

Die eingangs erwähnte Mischung von monomerer und polymerer Acryl- und Methacrylsäure bzw. monomeren und polymeren Acryl- und Methacrylsäureestern kann auch einen Ethylalkohol enthalten. Dies ist sinnvoll, wenn die Viskosität für die Verarbeitung zufolge eines größeren Gehalts an längeren Ketten schon zu hoch ist. Es liegt dann ein größerer Teil des Lackes bzw. Resists schon als Polymer vor. In diesem Fall kann dann aber zur Verbesserung der Reaktionsfähigkeit bzw. Polymerisationsfähigkeit ein weiterer Beschleuniger zugesetzt sein, z.B. ein Diacrylsäureester, etwa ein Dimethacrylsäureethylenglykolester, der den folgenden strukturellen Aufbau hat:

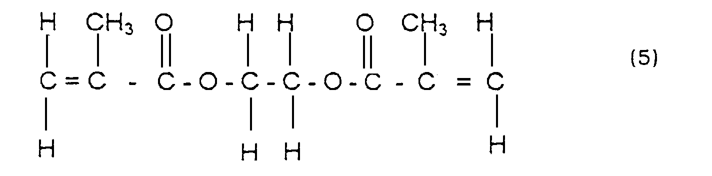

Zusätzlich können noch folgende Monomere den bisher beschriebenen Harzmischungen zugesetzt werden: Styrol, α-Methylstyrol, Vinyltoluol, 2-Chlorstyrol, 2,5-Dichlorstyrol, Vinylpyridin, Acrylsäure-t-butylester, Methacrylsäuremethylester, Divinylbenzol.

Alle diese Monomere sorgen zunächst für eine verbesserte Viskosität der Harze im Ausgangszustand und können daher zum Teil Lösungsmittel ersetzen, wobei sie bei der Polymerisation fest in das Harzgerüst eingebunden werden, was den Aushärtvorgang beschleunigt. Auch können Epoxidharze oder Aminoplaste mit den beschriebenen Acrylaten copolymerisiert werden.

Als Photoinitiator kommt vorzugsweise ein Metallocen zum Einsatz, um die Harzschicht für den sichtbaren Spektralbereich empfindlich zu machen. Hier kann z.B. das Produkt CGI 784 der Firma Ciba-Geigy verwendet werden, das folgende Strukturformel aufweist:

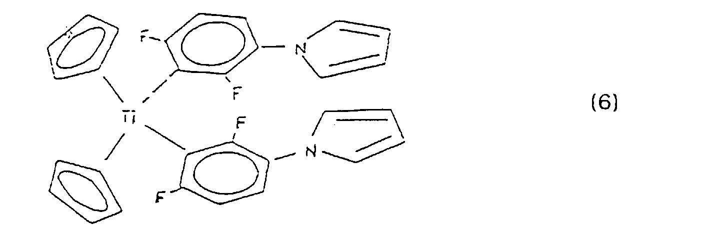

Es handelt sich hier um Bis(eta 5-2,4-cyclopentadien-1-yl)-bis[2,6-difluoro-3-(1H-pyrrol-1 yl)phenyl]titanium. Es kann mit anderen Substanzen vermischt sein, falls erforderlich.

Dieser Photoinitiatorwird dem Harz in Form einer Lösung zugesetzt. Dabei sind mögliche Lösungsmittel: Trimethylolpropantriacetat, Hexandioldiacrylat, N-Vinylpyrrolidon, Aceton, Toluol oder Methylethylketon. Dabei werden 0,3 bis 10 Gew.-% Photoinitiator bezogen auf das Harztrockengewicht verwendet. Dies ist das Harzgewicht ohne die nicht copolymerisierenden Lösemittel (z.B. Ethanol).

Ein derartiger Photolack weist eine hohe Empfindlichkeit bei einer Strahlungswellenlänge von z.B. λ = 488 nm auf, wobei gute Polymerisationsergebnisse erzielt werden bei Belichtung mittels eines Lasers, dessen Strahlausgangsleistung 150 mW beträgt.

Nachfolgend wird ein Beispiel einer Lackzusammensetzung im einzelnen angegeben. Alle Arbeiten zur Herstellung des Lackes wären dabei bei Rotlicht durchzuführen.

### a) Zusammensetzung:

1750,0 g NL 143 Nr. 5011, Phoresist der Fa. Morton Electronic Materials;
70,0 g Photoinitiator-Lösung gemäß Zubereitung b;
17,5 g roter Farbstoff Nr. 171294 der Firma Manoukian;
700,0 g Essigsäureethylester p.A. der Firma Riedel-de-Haen.

### b) Aufbereitung des Photoinitiators CGI 784 IP der Firma Ciba-Geigy;

Da der Photoinitiator aus Sicherheitsgründen mit Trägermaterial versetzt ist, muß der CGI 784 IP durch Extraktion davon getrennt werden.

Eine entsprechende Menge Photoinitiator wird mit der dreifachen Menge Methylethylketon p.A. (MEK) versetzt und eine Stunde bei Raumtemperatur (mittels eines Magnetrührers) gerührt. Anschließend wird über eine Schlitznutsche filtriert und bis zum Verschwinden der Gelbfärbung mit MEK nachgewaschen. Das Filtrat wird in einen Birnenkolben überführt und mittels Rotavapor bei 35 °C eingeengt. Der hochviskose (fast lösungsmittelfreie) Rückstand wird mit der entsprechenden Menge Essigsäureethylester (mittels Rotavapor bei 35 °C) gelöst und in einem lichtundurchlässigen Gefäß dicht verschlossen aufbewahrt.

Die Konzentration des fertigen Photoinitiators beträgt 200 mg CGI 784 IP/g Lösung.

### c) Zusammenmischen des Lackes:

Der Essigsäureethylester p.A. wird vorgelegt und mit der Photoinitiatorlösung versetzt (evtl. auskristallisierter Initiator geht somit in Lösung) und gerührt, anschließend werden der rote Farbstoff und dann der NL 143 eingetragen und gut gerührt. Filtriert wird der fertige Lack über eine Schlitznutsche und dann in einem lichtundurchlässigen Gefäß dicht verschlossen aufbewahrt.

Nachdem der so vorbereitete Lack mittels der Ring- bzw. Tauchringrakel 2 auf den hohlzylindrischen Trägerkörper 1 aufgebracht worden ist, wird die photoempfindliche Lackschicht möglichst vollständig getrocknet, d.h. es wird das Lösungsmittel abgedampft, welches aus verfahrenstechnischen Gründen in das Photopolymer eingebracht werden mußte. Hierzu werden die schon während des Beschichtungsvorgangs luftgetrockneten Schablonen in einem Warmluftofen nachgetrocknet, so daß keine Lösungsmittelreste in der Schicht mehr verbleiben. Gleichzeitig werden wichtige Eigenschaften durch diese Trocknung herbeigeführt oder zumindest beeinflußt. Die Haftung der photoempfindlichen Lackschicht am metallischen Untergrund des Trägerkörpers wird durch höhere Temperaturen verbessert, während aber gleichzeitig das optische Auflösungsvermögen verringert wird. Die Trocknung wird daher bei Temperaturen zwischen 20 °C und 85 °C durchgeführt und muß, um die genannten Eigenschaften gleichmäßig zu erhalten, sehr sorgfältig in bezug auf Zeit und Temperatur ausgeführt werden. Bei Lackschichten, die für die bessere oder raschere Vernetzung ein Monomer erfordern, ist während des Trocknungsvorgangs darauf Rücksicht zu nehmen, daß dieses nicht oder nur zu einem geringen Teil abdampfen darf. In diesem Fall wird das Photopolymer natürlich flüssig bleiben, was eine klebrige Oberfläche der Lackschicht zur Folge hat. Die Viskosität dieser Schicht wird aber durch Abdampfen der Verdünner sehr groß eingestellt, und darüber hinaus kann die Schicht in ihrer rheologischen Eigenschaft durch geeignete Additive bzw. Füllstoffe thixotrop eingestellt werden, so daß die noch unvernetzte Polymerschicht nicht abfließen kann.

Je nach Beschaffenheit der Polymer- bzw. Lackschicht L wird die Trocknung nun entweder so erfolgen, daß man den hohlzylindrischen Trägerkörper 1 in den Trockenofen stellt, d.h. daß die Achse 9 des Trägerkörpers 1 vertikal verläuft, oder man wird bei niedrigerer Viskosität der Lackschicht den Trägerkörper 1 auf horizontale Dorne aufschieben und diesen gegebenenfalls sogar in Drehung versetzen, so daß ein Abfließen der Polymerschicht am Beginn des Trocknungsprozesses verhindert wird.

Nachdem auf die Oberfläche des zylindrischen Trägerkörpers 1 die Photopolymerschicht aufgebracht worden ist, wird diese mit einer weiteren organischen Lackschicht L1 überzogen, und zwar mittels Tauchbeschichtung. Hierzu kann wiederum die bereits genannte Tauchringrakel (Gummirakel) verwendet werden.

Beispielsweise kann es sich bei der weiteren organischen Lackschicht L1 um eine Gelatineschicht, oder um eine solche Schicht handeln, die wenigstens ein in Wasser gelöstes Thermoplast enthält. Das Thermoplast kann ein Polyvinylalkohol sein, der zusätzlich auch einen Fettalkoholpolyglykolether enthalten kann.

Nachfolgend wird ein Bespiel einer derartigen weiteren organischen Lackschicht angegeben. Es handelt sich hier um eine 5-%ige PVA-Lösung mit 0,1 % Genapol T250. Genauer gesagt enthält die Lösung 100 g Polyvinylalkohol Artikel Nr. 318 der Firma Riedel-de-Haen, 2 g Genapol T250 der Firma Hoechst und 1898 g E-H₂O (entionisiertes Wasser). Bei dem Genapol T250 handelt es sich um einen Fettalkoholpolyglykolether.

Zur Zubereitung werden zunächst 1600 g E-H₂O bis zum Sieden erhitzt und unter Rühren wird 100 g PVA versetzt. Nachdem sich der PVA (Polyvinylalkohol) gelöst hat, setzt man 2 g Genapol T250 zu und rührt bis zum Erreichen einer glasklaren Lösung. Anschließend ergänzt man mit E-H₂O auf 2000 g Lösung, kühlt ab und filtriert über eine Schlitznutsche. Aufbewahrt wird die Lösung zunächst in einem dicht verschließbaren Gefäß. Sie kann dann in die Ringrakel überführt werden, um eine entsprechende Beschichtung der bereits auf dem hohlzylindrischen Trägerkörper 1 vorhandenen Potopolymerschicht L zu erhalten.

Danach erfolgt wiederum ein Trocknungsvorgang über bis zu maximal einer Stunde bei ca. 60 °C oder darunter. wie bereits zuvor beschrieben.

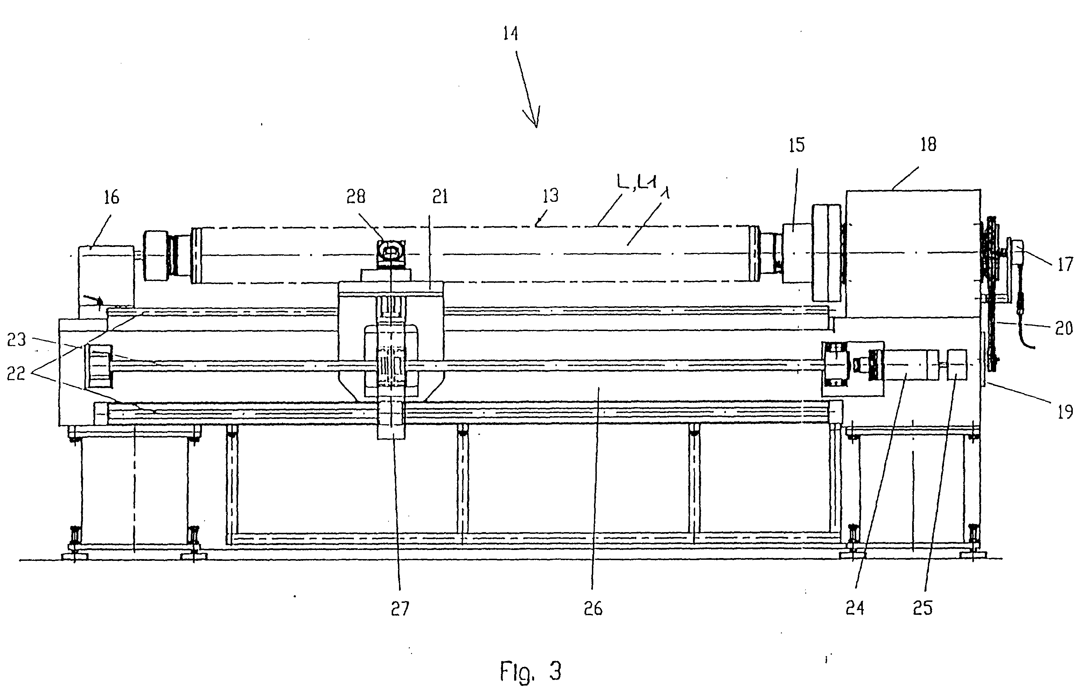

Anhand der Fig. 3 bis 6 wird der nachfolgende Verfahrensschritt der Belichtung mit Hilfe eines Lasers beschrieben. Durch diesen Laser wird die zu vernetzende Photopolymerschicht punktweise an den musterbedingt zu vernetzenden Stellen belichtet und damit verfestigt. Diese Stellen bleiben später nach der Entwicklung der Photopolymerschicht stehen.

Eine Rundform 13, darunter versteht man den mit dem Photopolymer beschichteten Trägerkörper 1, wird in eine Rotationsbelichtungsmaschine 14 zwischen ein Spannfutter 15 und einen Reitstock 16 eingelegt. Durch das Schließen des Spannfutters 15 wird mit der Rundform 13 ein Drehlagenencoder 17 drehsteif verbunden. Letzterer ist auf der rechten Seite eines Spindelstocks 18 der Rotationsbelichtungsmaschine 14 angeordnet. Der rotatorische Antrieb der Rundform 13 und der mit dieser verbundenen Anlageteile erfolgt durch einen Hauptantriebsmotor 19 über einen schwingungsgedämpften Keilriemenantrieb 20. Während sich die Rundform 13 dreht, wird ein Optikschlitten 21 entlang von Führungen 22 mit Hilfe einer Vorschubspindel 23 und einem mit dieser gekuppelten Schrittmotor 24 bewegt. Am rechten Wellenende des Schrittmotors 24 wird ein Drehschwingungsdämpfer 24 aufgesetzt. Die Führungen 22 und die Vorschubspindel 23 sind an einem Führungsbett 26 bzw. Maschinenbett der Rotationsbelichtungsmaschine 14 gelagert.

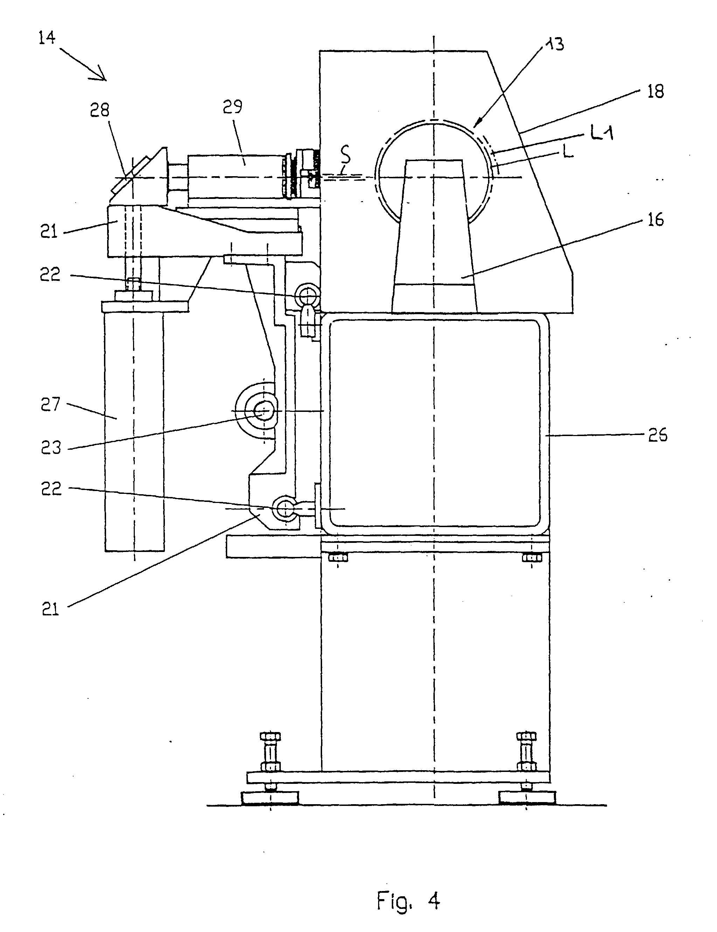

In den Fig. 3 und 4 ist ein mit dem Optikschlitten 21 mitgeführter Laser 27 vorhanden, dessen Laserstrahl S über einen Umlenkspiegel 28 aus der ursprünglich vertikalen Richtung in eine horizontale Richtung umgelenkt wird, so daß er dann über eine Optik 29 radial auf die Oberfläche der Rundform 13 fokussiert wird.

Zur Stabilisierung der Schablonenwandung in radialer und tangentialer Richtung können Führungselemente (Rollen. Gleitführungen) vorgesehen werden, jedoch ist dies natürlich nur bei solchen Photopolymeren möglich, welche schon im nichtvernetzten Zustand eine trockene, d.h. feste Oberfläche aufweisen.

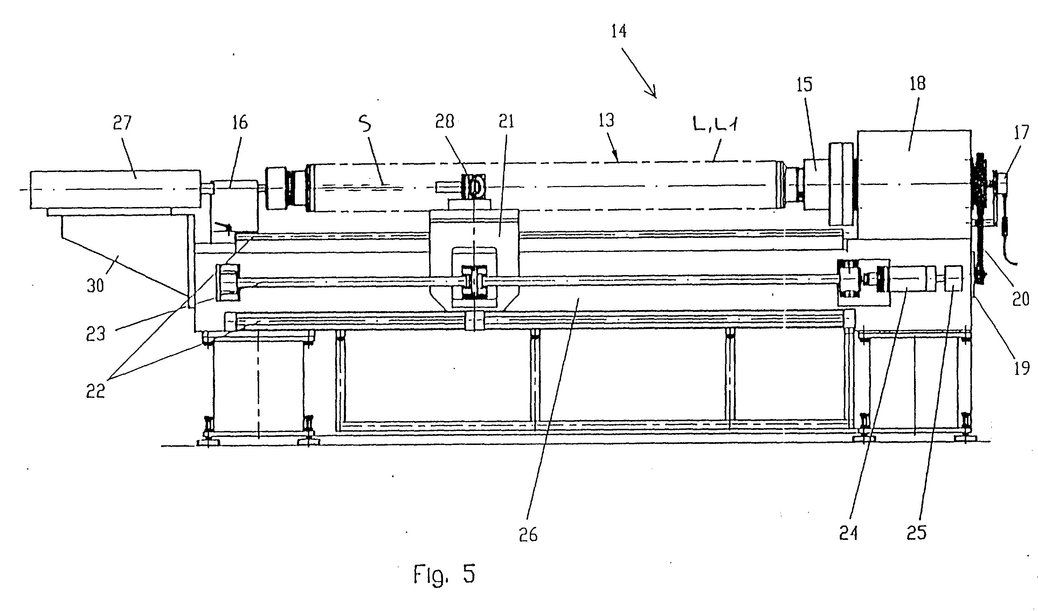

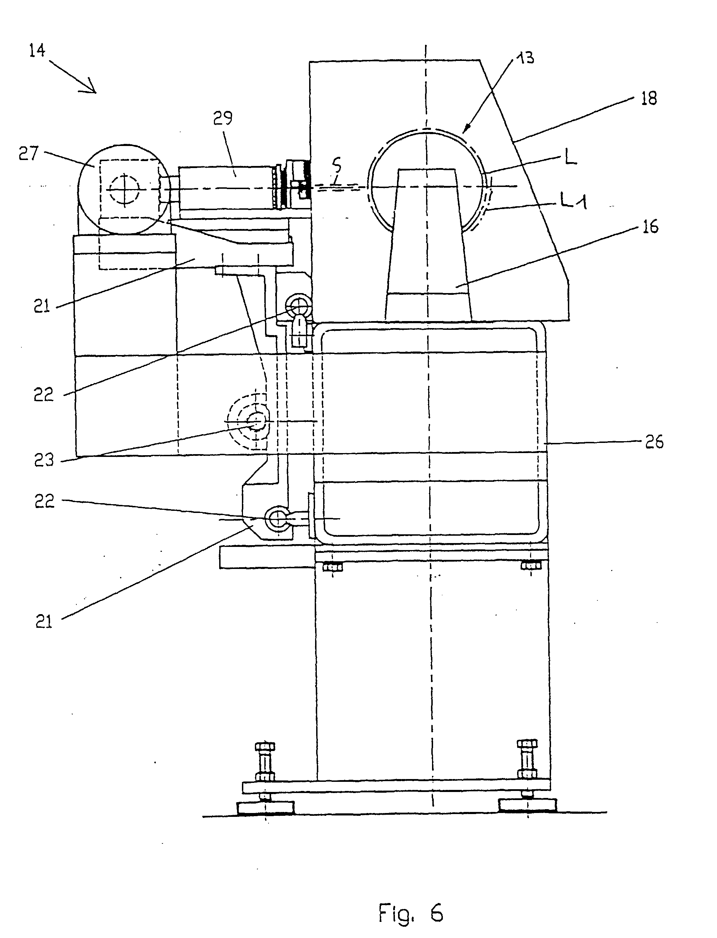

In den Fig. 5 und 6 ist ein ortsfester Laser 27 dargestellt, welcher am reitstockseitigen Ende der Rotationsbelichtungsmaschine 14 über eine Konsole 30 angebracht ist.

Zum Zwecke der punktweisen Belichtung der Oberfläche der Rundform 13 im Fokuspunkt der Optik 29 wird die Laserstrahlung z.B. über einen akustooptischen Modulator ein- oder ausgeschaltet. Für die hier benötigten Zwecke wird man vorzugsweise Quarzglas als Wechselwirkungs- oder Schaltmedium benutzen, da dieses für Licht im in Rede stehenden Wellenlängenbereich durchlässig ist und auch eine ausreichend hohe Schallgeschwindigkeit aufweist, welche für ein hinreichend schnelles Durchschalten des Modulators erforderlich ist. Obwohl am zweckmäßigsten der Strahl erster Ordnung Verwendung finden wird, also der an den Verdichtungszonen im Wechselwirkungsmedium reflektierte Strahl, weil dadurch ein 0:100 Tastverhältnis der Strahlleistung erreicht werden kann, ist es durchaus aber auch vorstellbar, den Strahl nullter Ordnung für die Oberflächenbelichtung der Rundform 13 heranzuziehen und die dadurch verursachte teilweise Vorvernetzung an den Stellen, die unbelichtet bleiben sollen, in Kauf zu nehmen. Der Entwicklungsprozeß für die Photopolymere, der im wesentlichen in einem Herauslösen der unvernetzten Polymere aus dem Oberflächenfilm besteht, ist durchaus auch in der Lage, teilweise vernetzte Stellen herauszulösen.

Der Laser 27 ist im vorliegenden Fall ein Argon-Ionen-Laser, dessen Strahlungswellenlänge bei 488 nm liegt, und der eine optische Strahlleistung von 150 mW aufweist. Durch den akustooptischen Modulator können Ein- und Ausschaltfrequenzen für den Laserstrahl S erzeugt werden, die im Bereich zwischen 1 MHz und 1,3 MHz liegen. Der Durchmesser des Fokusflecks nach der Fokussierung kann z.B. 20 µm betragen. Er kann zur Erzeugung anderer Musterstrukturen aber auch größer ausgebildet sein. Sollen z.B. Sechsecke mit einer Schlüsselweite von 330 µm erzeugt werden, so könnte der Durchmesser des Fokusflecks z.B. bei 45 µm zu liegen kommen.

In einem weiteren Verfahrensschritt wird nunmehr die auf dem hohlzylindrischen Trägerkörper 1 liegende oberste bzw. weitere organische Schicht L1 (PVA-Schicht) abgewaschen. Hierzu wird die Rundform 13 mit Wasser bei Raumtemperatur gespült.

Danach erfolgt das Entwickeln der Photolackschicht L. Zu diesem Zweck wird die Rundform in ein Entwicklermedium getaucht, welches sich in einer Wanne 31 befindet, und es werden dadurch die nicht durch die Lichteinwirkung vernetzten Stellen aus der auf dem Hohlzylinder liegenden Photopolymerschicht L herausgelöst. Zweckmäßigerweise kann die Entwicklerflüssigkeit aus einer alkalischen Lösung bestehen. Es kann sich hier z.B. um eine 1-%ige Sodalösung handeln, in der ca. 1,5 Minuten entwickelt wird. Zur Unterstützung des Entwicklungsvorgangs kann unverbrauchte Entwicklerlösung aus einer Brause 32 auf die Oberfläche der Rundform 32 aufgespult werden. Die Rundform 13 läuft während des Entwicklungsvorgangs im Sinne der Pfeilrichtung 33 um.

Danach wird wiederum die Rundform 13 mit Wasser gespült, und zwar bis zum Verschwinden des Schäumens.

Sodann erfolgt eine Trocknung der so entwickelten Rundform 13 bei ca. 60 ° oder darunter über maximal eine Stunde, vorzugsweise 15 Minuten.

Sofern es sich bei dem hohlzylindrischen Trägerkörper um ein bereits vorgefertigtes Sieb gehandelt hat, ist die Siebdruckschablone nunmehr fertiggestellt.

Hat es sich bei dem hohlzylindrischen Trägerköper 1 allerdings um einen solchen mit geschlossener Wandoberfläche gehandelt, so erfolgt anschließend ein Galvanisierungsvorgang, um die im Lack infolge der Entwicklung entstandenen Lücken mit Metall aufzufüllen. Auf diese Weise entsteht auf der Oberfläche des Hohlzylinders 1 je nach Musterung der Lackschicht L eine Siebdruckschablone, die anschließend vom Hohlzylinder 1 abgenommen wird.

## Patentansprüche (Patentansprüche für folgende(n) Vertragsstaat(en): DE, FR, GB)

1. Verfahren zum Herstellen einer Siebdruckschablone, insbesondere zum Bedrucken von Textilien, bei dem ein an seiner äußeren Oberfläche mit einer flüssig aufgetragenen Lackschicht (L) beschichteter metallischer Trägerkörper (1) mittels eines Laserstrahls (S) bestrahlt wird, um in diese ein gewünschtes Muster einzubringen, wobei die Strahlungswellenlänge des Laserstrahls (S) größer als 450 nm ist, **dadurch gekennzeichnet,** daß die Ein-Ausschaltfrequenz des Laserstrahls (S) im Bereich von 1,0 bis 1,3 MHz liegt.

2. Verfahren nach Anspruch 1, **dadurch gekennzeichnet,** daß die Strahlungswellenlänge des Laserstrahls (S) im sichtbaren Spektralbereich liegt.

3. Verfahren nach Anspruch 1, **dadurch gekennzeichnet,** daß die Strahlungswellenlänge des Laserstrahls (S) bei etwa 488 nm liegt.

4. Verfahren nach Anspruch 1, dadurch gekennzeichnet, daß die Strahlungswellenlänge des Laserstrahls (S) im infraroten Spektralbereich liegt.

5. Verfahren nach einem der Ansprüche 1 bis 4, **dadurch gekennzeichnet**, daß die optische Strahlleistung des Laserstrahls (S) bei etwa 150 mW liegt.

6. Verfahren nach einem der Ansprüche 1 bis 5, **dadurch gekennzeichnet**, daß die Lackschicht (L) durch den Laserstrahl (S) weggebrannt wird.

7. Verfahren nach einem der Ansprüche 1 bis 5, **dadurch gekennzeichnet**, daß die Lackschicht (L) eine polymerisierbare Schicht ist, die durch den auftreffenden Laserstrahl (S) bereichsweise vernetzt und später entwickelt wird.

8. Verfahren nach Anspruch 7, **dadurch gekennzeichnet**, daß zur Bildung der Lackschicht (L) ein Lack aufgetragen wird, der wenigstens einen Negativ-Flüssigresist mit wenigstens einem darin vorhandenen Photoinitiator aufweist.

9. Verfahren nach Anspruch 8, **dadurch gekennzeichnet**, daß der Lack einen leicht abdampfbaren Verdünner enthält.

10. Verfahren nach Anspruch 8 oder 9, **dadurch gekennzeichnet**, daß der Lack einen Farbstoff enthält, dessen Farbe vorzugsweise komplementär zu der der Strahlungswellenlänge entsprechenden Farbe ist.

11. Verfahren nach einem der Ansprüche 1 bis 10, **dadurch gekennzeichnet**, daß vor der Bestrahlung der Lackschicht (L) auf diese eine weitere organische Lackschicht (L1) aufgetragen wird.

12. Verfahren nach Anspruch 11, **dadurch gekennzeichnet**, daß die organische Lackschicht (L1) eine Gelatineschicht ist.

13. Verfahren nach Anspruch 11, **dadurch gekennzeichnet,** daß die organische Lackschicht (L1)wenigstens ein in Wasser gelöstes Thermoplast enthält.

14. Verfahren nach Anspruch 13, **dadurch gekennzeichnet**, daß das Thermoplast ein Polyvinylalkohol ist.

15. Verfahren nach Anspruch 13 oder 14, **dadurch gekennzeichnet,** daß das Thermoplast zusätzlich einen Fettalkoholpolyglykolether enthält.

16. Verfahren nach Anspruch 13, 14 oder 15, **dadurch gekennzeichnet,** daß das Wasser entionisiert ist.

17. Verfahren nach einem der Ansprüche 6 bis 16, **dadurch gekennzeichnet**, daß als Trägerkörper (1) ein metallischer Hohlzylinder mit siebförmiger Mantelfläche verwendet wird.

18. Verfahren nach einem der Ansprüche 6 bis 16, **dadurch gekennzeichnet,** daß als Trägerkörper (1) ein metallischer Zylinder mit geschlossener Mantelfläche bereitgestellt wird, auf die nach musterbedingter Entfernung der Lackschicht (L) Metall galvanisch aufgebracht wird, um eine Siebdruckschablone zu erhalten.

19. Verfahren nach Anspruch 17, **dadurch gekennzeichnet**, daß die Lackschicht (L) und/oder die weitere Lackschicht (L1) bei vertikal angeordnetem Hohlzylinder (1) mittels einer Ringrakel (2) aufgebracht wird.

20. Verfahren nach Anspruch 18, **dadurch gekennzeichnet**, daß die Lackschicht (L) und/oder die weitere Lackschicht (L1) bei vertikal angeordnetem Zylinder (1) mittels einer Tauchringrakel (2) aufgebracht wird, die von oben nach unten geführt wird.

21. Verfahren nach einem der Ansprüche 11 bis 20, **dadurch gekennzeichnet**, daß unmittelbar nach dem Auftragen der Lackschicht (L) bzw. der weiteren Lackschicht (L1) oder nach dem Entwickeln ein Trocknungsschritt erfolgt.

22. Verfahren nach einem der Ansprüche 8 bis 20, **dadurch gekennzeichnet,** daß der Lack zusätzlich ein Monomer enthält.

## Patentansprüche (Patentansprüche für folgende(n) Vertragsstaat(en): AT, CH, ES, IT, NL)

1. Verfahren zum Herstellen einer Siebdruckschablone, insbesondere zum Bedrucken von Textilien, bei dem ein an seiner äußeren Oberfläche mit einer Lackschicht (L) beschichteter Trägerkörper (1) mittels eines Laserstrahls (S) bestrahlt wird, um in diese ein gewünschtes Muster einzubringen, wobei die Strahlungswellenlänge des Laserstrahls (S) größer als 450 nm ist, **dadurch gekennzeichnet**, daß die Ein-Ausschaltfrequenz des Laserstrahls (S) im Bereich von 1,0 bis 1,3 MHz liegt).

2. Verfahren nach Anspruch 1, **dadurch gekennzeichnet**, daß die Strahlungswellenlänge des Laserstrahls (S) im sichtbaren Spektralbereich liegt.

3. Verfahren nach Anspruch 1, **dadurch gekennzeichnet**, daß die Strahlungswellenlänge des Laserstrahls (S) bei etwa 488 nm liegt.

4. Verfahren nach Anspruch 1, **dadurch gekennzeichnet**, daß die Strahlungswellenlänge des Laserstrahls (S) im infraroten Spektralbereich liegt.

5. Verfahren nach einem der Ansprüche 1 bis 4, **dadurch gekennzeichnet**, daß die optische Strahlleistung des Laserstrahls (S) bei etwa 150 mW liegt.

6. Verfahren nach einem der Ansprüche 1 bis 5, **dadurch gekennzeichnet,** daß die Lackschicht (L) durch den Laserstrahl (S) weggebrannt wird.

7. Verfahren nach einem der Ansprüche 1 bis 5, **dadurch gekennzeichnet,** daß die Lackschicht (L) eine polymerisierbare Schicht ist, die durch den auftreffenden Laserstrahl (S) bereichsweise vernetzt und später entwickelt wird.

8. Verfahren nach Anspruch 7, **dadurch gekennzeichnet**, daß zur Bildung der Lackschicht (L) ein Lack aufgetragen wird, der wenigstens einen Negativ-Flüssigresist mit wenigstens einem darin vorhandenen Photoinitiator aufweist.

9. Verfahren nach Anspruch 8, **dadurch gekennzeichnet**, daß der Lack einen leicht abdampfbaren Verdünner enthält.

10. Verfahren nach Anspruch 8 oder 9, **dadurch gekennzeichnet**, daß der Lack einen Farbstoff enthält, dessen Farbe vorzugsweise komplementär zu der der Strahlungswellenlänge entsprechenden Farbe ist.

11. Verfahren nach einem der Ansprüche 1 bis 10, **dadurch gekennzeichnet,** daß vor der Bestrahlung der Lackschicht (L) auf diese eine weitere organische Lackschicht (L1) aufgetragen wird.

12. Verfahren nach Anspruch 11, **dadurch gekennzeichnet**, daß die organische Lackschicht (L1) eine Gelatineschicht ist.

13. Verfahren nach Anspruch 11, **dadurch gekennzeichnet**, daß die organische Lackschicht (L1) wenigstens ein in Wasser gelöstes Thermoplast enthält.

14. Verfahren nach Anspruch 13, **dadurch gekennzeichnet**, daß das Thermoplast ein Polyvinylalkohol ist.

15. Verfahren nach Anspruch 13 oder 14, **dadurch gekennzeichnet,** daß das Thermoplast zusätzlich einen Fettalkoholpolyglykolether enthält.

16. Verfahren nach Anspruch 13, 14 oder 15, **dadurch gekennzeichnet**, daß das Wasser entionisiert ist.

17. Verfahren nach einem der Ansprüche 6 bis 16**, dadurch gekennzeichnet**, daß als Trägerkörper (1) ein metallischer Hohlzylinder mit siebförmiger Mantelfläche verwendet wird.

18. Verfahren nach einem der Ansprüche 6 bis 16, **dadurch gekennzeichnet,** daß als Trägerkörper (1) ein metallischer Zylinder mit geschlossener Mantelfläche bereitgestellt wird, auf die nach musterbedingter Entfernung der Lackschicht (L) Metall galvanisch aufgebracht wird, um eine Siebdruckschablone zu erhalten.

19. Verfahren nach Anspruch 17, **dadurch gekennzeichnet,** daß die Lackschicht (L) und/oder die weitere Lackschicht (L1) bei vertikal angeordnetem Hohlzylinder (1) mittels einer Ringrakel (2) aufgebracht wird.

20. Verfahren nach Anspruch 18, **dadurch gekennzeichnet**, daß die Lackschicht (L) und/oder die weitere Lackschicht (L1) bei vertikal angeordnetem Zylinder (1) mittels einer Tauchringrakel (2) aufgebracht wird, die von oben nach unten geführt wird.

21. Verfahren nach einem der Ansprüche 11 bis 20, **dadurch gekennzeichnet**, daß unmittelbar nach dem Auftragen der Lackschicht (L) bzw. der weiteren Lackschicht (L1) oder nach dem Entwickeln ein Trocknungsschritt erfolgt.

22. Verfahren nach einem der Ansprüche 8 bis 20, **dadurch gekennzeichnet**, daß der Lack zusätzlich ein Monomer enthält.

## Claims (Claims for the following Contracting State(s): DE, FR, GB)

1. Method for producing a screen printing stencil, in particular for printing textiles, in which a support (1) coated on its outer surface with a lacquer layer (L) is exposed to a laser beam (S) in order to introduce a desired pattern into said lacquer layer, the radiation wavelength of the laser beam (S) being greater than 450 nm, characterized in that the on/off frequency of the laser beam (S) is in the range from 1.0 to 1.3 MHz.

2. Method according to Claim 1, characterized in that the radiation wavelength of the laser beam (S) is in the visible spectral range.

3. Method according to Claim 1, characterized in that the radiation wavelength of the laser beam (S) is about 488 nm.

4. Method according to Claim 1, characterized in that the radiation wavelength of the laser beam (S) is in the infrared spectral range.

5. Method according to one of Claims 1 to 4, characterized in that the optical radiant power of the laser beam (S) is about 150 mW.

6. Method according to one of Claims 1 to 5, characterized in that the lacquer layer (L) is burnt away by means of the laser beam (S).

7. Method according to one of Claims 1 to 5, characterized in that the lacquer layer (L) is a polymerizable layer which is crosslinked in parts by the incident laser beam (S) and is subsequently developed.

8. Method according to Claim 7, characterized in that a lacquer which has at least one negative liquid resist with at least one photoinitiator present therein is applied for forming the lacquer layer (L).

9. Method according to Claim 8, characterized in that the lacquer contains a thinner which can be readily evaporated off.

10. Method according to Claim 8 or 9, characterized in that the lacquer contains a dye whose colour is preferably complementary to the colour corresponding to the radiation wavelength.

11. Method according to one of Claims 1 to 10, characterized in that a further organic lacquer layer (L1) is applied to the lacquer layer (L) before the latter is irradiated.

12. Method according to Claim 11, characterized in that the organic lacquer layer (L1) is a gelatine layer.

13. Method according to Claim 11, characterized in that the organic lacquer layer (L1) contains at least one thermoplastic dissolved in water.

14. Method according to Claim 13, characterized in that the thermoplastic is a polyvinyl alcohol.

15. Method according to Claim 13 or 14, characterized in that the thermoplastic additionally contains a fatty alcohol polyglycol ether.

16. Method according to Claim 13, 14 or 15, characterized in that the water is demineralized.

17. Method according to one of Claims 6 to 16, characterized in that the support (1) used is a metallic hollow cylinder having a perforated lateral surface.

18. Method according to one of Claims 6 to 16, characterized in that the support (1) provided is a metallic cylinder which has a closed lateral surface and on which, after removal of the lacquer layer (L) in accordance with the pattern, metal is galvanically applied in order to obtain a screen printing stencil.

19. Method according to Claim 17, characterized in that the lacquer layer (L) and/or the further lacquer layer (L1) are applied by means or a ring coater (2) with the hollow cylinder (1) arranged vertically.

20. Method according to Claim 18, characterized in that the lacquer layer (L) and/or the further lacquer layer (L1) is applied by means of an immersion ring coater (2) which is moved from top to bottom, with the cylinder (1) arranged vertically.

21. Method according to one of Claims 11 to 20, characterized in that a drying step is carried out immediately after the application of the lacquer layer (L) or of the further lacquer layer (L1) or after the development.

22. Method according to one of Claims 8 to 20, characterized in that the lacquer additionally contains a monomer.

## Claims (Claims for the following Contracting State(s): AT,CH, ES, IT, NL)

1. Method for producing a screen printing stencil, in particular for printing textiles, in which a metal support (1) coated on its outer surface with a lacquer layer (L) applied in liquid form is exposed to a laser beam (S) in order to introduce a desired pattern into said lacquer layer, the radiation wavelength of the laser beam (S) being greater than 450 nm, characterized in that the on/off frequency of the laser beam (S) is in the range from 1.0 to 1.3 MHz.

2. Method according to Claim 1, characterized in that the radiation wavelength of the laser beam (S) is in the visible spectral range.

3. Method according to Claim 1, characterized in that the radiation wavelength of the laser beam (S) is about 488 nm.

4. Method according to Claim 1, characterized in that the radiation wavelength of the laser beam (S) is in the infrared spectral range.

5. Method according to one of Claims 1 to 4, characterized in that the optical radiant power of the laser beam (S) is about 150 mW.

6. Method according to one of Claims 1 to 5, characterized in that the lacquer layer (L) is burnt away by means of the laser beam (S).

7. Method according to one of Claims 1 to 5, characterized in that the lacquer layer (L) is a polymerizable layer which is crosslinked in parts by the incident laser beam (S) and is subsequently developed.

8. Method according to Claim 7, characterized in that a lacquer which has at least one negative liquid resist with at least one photoinitiator present therein is applied for forming the lacquer layer (L).

9. Method according to Claim 8, characterized in that the lacquer contains a thinner which can be readily evaporated off.

10. Method according to Claim 8 or 9, characterized in that the lacquer contains a dye whose colour is preferably complementary to the colour corresponding to the radiation wavelength.

11. Method according to one of Claims 1 to 10, characterized in that a further organic lacquer layer (L1) is applied to the lacquer layer (L) before the latter is irradiated.

12. Method according to Claim 11, characterized in that the organic lacquer layer (L1) is a gelatine layer.

13. Method according to Claim 11, characterized in that the organic lacquer layer (L1) contains at least one thermoplastic dissolved in water.

14. Method according to Claim 13, characterized in that the thermoplastic is a polyvinyl alcohol.

15. Method according to Claim 13 or 14, characterized in that the thermoplastic additionally contains a fatty alcohol polyglycol ether.

16. Method according to Claim 13, 14 or 15, characterized in that the water is demineralized.

17. Method according to one of Claims 6 to 16, characterized in that the support (1) used is a metallic hollow cylinder having a perforated lateral surface.

18. Method according to one of Claims 6 to 16, characterized in that the support (1) provided is a metallic cylinder which has a closed lateral surface and on which, after removal of the lacquer layer (L) in accordance with the pattern, metal is galvanically applied in order to obtain a screen printing stencil.

19. Method according to Claim 17, characterized in that the lacquer layer (L) and/or the further lacquer layer (L1) are applied by means of a ring coater (2) with the hollow cylinder (1) arranged vertically.

20. Method according to Claim 18, characterized in that the lacquer layer (L) and/or the further lacquer layer (L1) is applied by means of an immersion ring coater (2) which is moved from top to bottom, with the cylinder (1) arranged vertically.

21. Method according to one of Claims 11 to 20, characterized in that a drying step is carried out immediately after the application of the lacquer layer (L) or of the further lacquer layer (L1) or after the development.

22. Method according to one of Claims 8 to 20, characterized in that the lacquer additionally contains a monomer.

## Revendications (Revendications pour l'(les) Etat(s) contractant(s) suivant(s): DE, FR, GB)

1. Procédé de fabrication d'un écran de sérigraphie, en particulier pour l'impression de textiles, dans lequel un corps support (1), revêtu sur sa face extérieure d'une couche de vernis (L), est irradié au moyen d'un rayon laser (S) afin d'introduire dans cette couche un motif souhaité, la longueur d'onde de rayonnement du rayon laser (S) étant supérieure à 450 nanomètres, caractérisé en ce que la fréquence de commutation-coupure du rayon laser (S) est située dans la plage de 1,0 à 1,3 MHz.

2. Procédé selon la revendication 1, caractérisé en ce que la longueur d'onde de rayonnement du rayon laser (S) est située dans la plage spectrale visible.

3. Procédé selon la revendication 1, caractérisé en ce que la longueur d'onde de rayonnement du rayon laser (S) est située à environ 488 nm.

4. Procédé selon la revendication 1, caractérisé en ce que la longueur d'onde de rayonnement du rayon laser (S) est située dans la plage spectrale des infrarouges.

5. Procédé selon l'une des revendications 1 à 4, caractérisé en ce que la puissance de rayonnement optique du rayon laser (S) est d'environ 150 mW.

6. Procédé selon l'une des revendications 1 à 5, caractérisé en ce que la couche de vernis (L) est éliminée par cuisson au moyen du rayon laser (S).

7. Procédé selon l'une des revendications 1 à 5, caractérisé en ce que la couche de vernis (L) est une couche polymérisable qui est réticulée par zones au moyen du rayon laser (S) incident et est ultérieurement développé.

8. Procédé selon la revendication 7, caractérisé en ce que pour former la couche de vernis (L) on applique un vemis qui présente au moins un résist liquide négatif avec au moins un photoinitiateur y étant contenu.

9. Procédé selon la revendication 8, caractérisé en ce que le vemis contient un diluant facilement évaporable.

10. Procédé selon la revendication 8 ou 9, caractérisé en ce que le vernis contient un colorant dont la couleur est de préférence complémentaire de la couleur correspondant à la longueur d'onde de rayonnement.

11. Procédé selon l'une des revendications 1 à 10, caractérisé en ce que, avant l'irradiation de la couche de vernis (L), on applique sur celle-ci une autre couche de vernis (L1) de nature organique.

12. Procédé selon la revendication 11, caractérisé en ce que la couche de vernis (L1) organique est une couche de gélatine.

13. Couche de vernis selon la revendication 11, caractérisé en ce que la couche de vernis (L1) organique contient au moins un thermoplastique dilué dans l'eau.

14. Procédé selon la revendication 13, caractérisé en ce que le thermoplastique est un alcool polyvinylique.

15. Procédé selon la revendication 13 ou 14, caractérisé en ce que le thermoplastique contient en plus un polyglycoléther d'alcool gras.

16. Procédé selon la revendication 13, 14, ou 15, caractérisé en ce que l'eau est déionisée.

17. Procédé selon l'une des revendications 6 à 16, caractérisé en ce que l'on utilise comme corps support (1) un cylindre creux métallique, ayant une surface d'enveloppe en forme d'écran.

18. Procédé selon l'une des revendications 6 à 16, caractérisé en ce qu'on prépare comme corps support (1) un cylindre métallique ayant une surface d'enveloppe fermée, sur laquelle, après avoir procédé à un enlèvement, imputable au motif, de la couche de vernis (L) on applique du métal par voie galvanique, afin d'obtenir un écran de sérigraphie.

19. Procédé selon la revendication 17, caractérisé en ce que la couche de vernis (L) et/ou l'autre couche de vernis (L1) sont appliquées au moyen d'une racle annulaire (2), alors que le cylindre creux (1) est disposé verticalement.

20. Procédé selon la revendication 18, caractérisé en ce que la couche de vernis (L) et/ou l'autre couche de vernis (L1) sont appliquées au moyen d'une racle annulaire à immersion (2) alors que le cylindre (1) est disposé verticalement, la racle étant guidée du haut vers le bas.

21. Procédé selon l'une des revendications 11 à 20, caractérisé en ce que l'on effectue une étape de séchage après application de la couche de vernis (L) ou de l'autre couche de vernis (L1) ou après le développement.

22. Procédé selon l'une des revendications 8 à 20, caractérisé en ce que le vernis contient en plus un monomère.

## Revendications (Revendications pour l'(les) Etat(s) contractant(s) suivant(s): AT, CH, ES, IT, NL)

1. Procédé de fabrication d'un écran de sérigraphie, en particulier pour l'impression de textiles, dans lequel un corps support (1) métallique, revêtu sur sa face extérieure d'une couche de vernis (L) appliquée à l'état liquide, est irradié au moyen d'un rayon laser (S) afin d'introduire dans cette couche un motif souhaité, la longueur d'onde de rayonnement du rayon laser (S) étant supérieure à 450 nanomètres, caractérisé en ce que la fréquence de commutation-coupure du rayon laser (S) est située dans la plage de 1,0 à 1,3 MHz.

2. Procédé selon la revendication 1, caractérisé en ce que la longueur d'onde de rayonnement du rayon laser (S) est située dans la plage spectrale visible.

3. Procédé selon la revendication 1, caractérisé en ce que la longueur d'onde de rayonnement du rayon laser (S) est située à environ 488 nm.

4. Procédé selon la revendication 1, caractérisé en ce que la longueur d'onde de rayonnement du rayon laser (S) est située dans la plage spectrale des infrarouges.

5. Procédé selon l'une des revendications 1 à 4, caractérisé en ce que la puissance de rayonnement optique du rayon laser (S) est d'environ 150 mW.

6. Procédé selon l'une des revendications 1 à 5, caractérisé en ce que la couche de vernis (L) est éliminée par cuisson au moyen du rayon laser (S).

7. Procédé selon l'une des revendications 1 à 5, caractérisé en ce que la couche de vernis (L) est une couche polymérisable qui est réticulée par zones au moyen du rayon laser (S) incident et est ultérieurement développé.

8. Procédé selon la revendication 7, caractérisé en ce que pour former la couche de vernis (L) on applique un vernis qui présente au moins un résist liquide négatif avec au moins un photoinitiateur y étant contenu.

9. Procédé selon la revendication 8, caractérisé en ce que le vernis contient un diluant facilement évaporable.

10. Procédé selon la revendication 8 ou 9, caractérisé en ce que le vernis contient un colorant dont la couleur est de préférence complémentaire de la couleur correspondant à la longueur d'onde de rayonnement.

11. Procédé selon l'une des revendications 1 à 10, caractérisé en ce que, avant l'irradiation de la couche de vernis (L), on applique sur celle-ci une autre couche de vernis (L1) de nature organique.

12. Procédé selon la revendication 11, caractérisé en ce que la couche de vernis (L1) organique est une couche de gélatine.

13. Couche de vernis selon la revendication 11, caractérisé en ce que la couche de vernis (L1) organique contient au moins un thermoplastique dilué dans l'eau.

14. Procédé selon la revendication 13, caractérisé en ce que le thermoplastique est un alcool polyvinylique.

15. Procédé selon la revendication 13 ou 14, caractérisé en ce que le thermoplastique contient en plus un polyglycoléther d'alcool gras.

16. Procédé selon la revendication 13, 14, ou 15, caractérisé en ce que l'eau est déionisée.

17. Procédé selon l'une des revendications 6 à 16, caractérisé en ce que l'on utilise comme corps support (1) un cylindre creux métallique, ayant une surface d'enveloppe en forme d'écran.

18. Procédé selon l'une des revendications 6 à 16, caractérisé en ce qu'on prépare comme corps support (1) un cylindre métallique ayant une surface d'enveloppe fermée, sur laquelle, après avoir procédé à un enlèvement, imputable au motif, de la couche de vernis (L) on applique du métal par voie galvanique, afin d'obtenir un écran de sérigraphie.

19. Procédé selon la revendication 17, caractérisé en ce que la couche de vernis (L) et/ou l'autre couche de vernis (L1) sont appliquées au moyen d'une racle annulaire (2), alors que le cylindre creux (1) est disposé verticalement.

20. Procédé selon la revendication 18, caractérisé en ce que la couche de vernis (L) et/ou l'autre couche de vernis (L1) sont appliquées au moyen d'une racle annulaire à immersion (2) alors que le cylindre (1) est disposé verticalement, la racle étant guidée du haut vers le bas.

21. Procédé selon l'une des revendications 11 à 20, caractérisé en ce que l'on effectue une étape de séchage après application de la couche de vernis (L) ou de l'autre couche de vernis (L1) ou après le développement.

22. Procédé selon l'une des revendications 8 à 20, caractérisé en ce que le vernis contient en plus un monomère.
